# EUROPEAN PATENT APPLICATION

(11) **EP 4 753 144 A1**
(43) Date of publication of application: **03.06.2026**
(21) Application number: 24216570.2
(22) Date of filing: 29.11.2024
(51) Int. Cl.: H02S 20/26, H10F 19/80, H10F 77/42

(54) **PHOTOVOLTAIC MODULE COMPRISING A DECORATIVE FILM INTERLAYER**

(71) Applicant: V3D B.V., 2741 CS Waddinxveen (NL)
(72) Inventor: VAN DIJKEN, Max, 2741 CS Waddinxveen (NL)
(74) Representative: V.O.

(57) **Abstract**

The invention relates to a photovoltaic module, comprising a decorative film, wherein the decorative film (4) is an interlayer between a front pane (5) and a layer comprising photovoltaic cells (8).

Typically, the substrate film is a substrate film interlayer (2), wherein the graphics coating (1) is present at a first side of the substrate interlayer (2), and the interference layer (3) is present at a second, opposing side of the substrate film interlayer.

## Description

The invention relates to a decorative film, to a photovoltaic module, to a method for producing a photovoltaic module, to an infrastructure, such as a building, comprising the photovoltaic module and to the use of a photovoltaic module as a solar panel to produce electricity.

With growing environmental awareness and the increasing need for sustainable buildings, Building-Integrated Photovoltaics (BIPV) has gained prominence. The drive for nearly Zero-Energy Buildings (nZEB) and Zero-Energy Buildings (ZEB) underpins the rising demand for BIPV solutions, which offer both functional energy generation and aesthetic integration with architectural elements. Regulations mandating energy efficiency further accelerate the need for innovations in BIPV technology that blend aesthetic appeal with energy performance.

Products like Morphocolor^{®} and Kromatix^{™} utilise interference coatings applied to the front glass of photovoltaic modules. These coatings provide a visually appealing finish by creating colours through interference, rather than pigments or dyes.

WO2023/194420A1 relates to a coloured solar cell module comprising two or more transparent front cover layers, each of said transparent front cover layers containing at least one effect pigment that has a specific colour.

Another approach that has been considered in the art is ceramic printing with regular ceramic inks on the front glass for adding colour and design to PV module glass, providing consistent results in specific colour ranges. While effective, they lack the low electric loss compared to interference pigments and are confined to be used on glass front sheets.

Yet another approach is to work with interlayers and Encapsulants, such as described in EP 3 782 201 A1, EP2 992 561 A1, or EP 4 084 089 A1. EP 3 782 201 A1 describes a coloured PV module and method of manufacture thereof using an interlayer that provides a single colour within the PV module. The interlayer comprises pigment particles distributed in two different zones. EP2 992 561 A1 outlines a multi layered solar cell device including a white multilayered film using beaded diffusers that adds visual uniformity to PV modules. However, it limits aesthetic variety, as it is primarily designed to achieve a white appearance.

EP 4 084 089 A1 describes an encapsulant technology offering a standardised colour solution, by combining the adhesive functionality of an encapsulant with a coloured appearance by including effect pigments in the front encapsulant of the PV module.

While current BIPV technologies offer some aesthetic customisation, there are generally limitations, e.g. in terms of the complexity of the decorations that can be applied, such as in a limitation of being able to use only one colour (mono-colours on interference basis), in terms of compatibility with various front sheet materials, such as, ornamental glass, plastic, and different PV module sizes. Existing options are either too rigid, limiting them to glass, or lack sufficient image customizability, resulting in greater losses in PV yield and reduced versatility, or they need a multilayer stack of different products that need to be encapsulated/glued together during the manufacturing process of the PV module.

Thus, there is in general a need for alternative photovoltaic modules not only providing electricity but also allowing aesthetic integration with architectural elements.

The present inventor found that it is possible to provide such alternative, in particular to provide a novel photovoltaic module that addresses one or more drawbacks of the prior art such as outlined above or elsewhere in the present disclosure. More in particular it is an object of the present invention to address at least two critical barriers to broader BIPV adoption: aesthetics and performance.

The inventor found in particular that a specific decorative interlayer can be included in a photovoltaic module which addresses an object of the invention.

Accordingly, the present invention relates to a decorative film (4), comprising a graphics coating (1), a substrate film layer (2) and an interference layer (3). Typically, the substrate film (4) is an interlayer (2), wherein the substrate film interlayer (2) is provided with a graphics coating (1), which is present on a first side of the substrate film interlayer (2), and an interference layer (3), which is present on a second, opposing side of the substrate film interlayer. In a specific embodiment, the interference layer (3) is present between the substrate film (2) and the graphics coating (1).

The decorative film (4) according to the invention is suitable as an interlayer of a photovoltaic module, when positioned between a front pane (5) (at a light incident side of the PV module) and PV cells present (at an opposite side). The decorative film (4) is partially transmissive for light, in particular sunlight. The concept of transmittivity and items, such as films, layers, coatings, materials etc, being partially transmissive is generally known in the art. The skilled person will also be able to determine whether an item for a photovoltaic module has satisfactory transmittivity based on common general knowledge, the prior art cited herein and the present disclosure. For its decorative purpose, in use, the decorative film, the graphics coating respectively the part of the photovoltaic module closer to the light incident side than the photovoltaic cells of the module absorbs part of the light that is reflected by the interference layer on the cell side of the substrate film (2), dependent at least on the type and amount of colouring agent(s) of the graphics coating, and allows a significant part of an incoming light to pass through. In a PV module the light that passed through the parts closer to the light incident side reaches the photovoltaic cells. Advantageously, a partially light-transmissive film, layer, coating, films, material etc. in accordance with the invention has a light transmissivity of at least about 50 % of light, more preferably of 60-90 % of light, in particular 65-80 % of light; herein the light is in particular sunlight herein the light in particular includes visible (sun) light and near-infrared sunlight, with a wavelength of up to about 1200 nm, more in particular (sun) light in a wavelength in a range of about 300 to about 1200 nm.

The decorative film is typically positioned in the PV module such that the graphics coating is facing the front pane, in other words the graphics coating (1) is typically positioned at the light incident side of the PV module, relative to the interference layer (2). When installed and exposed to light a decoration can be seen through the front pane, caused by the graphics coating (1) in combination with the interference layer (3) of the decorative film (4). Thus the PV module has a decorative element. The decorative film is partially transmissive, allowing sufficient incident light to pass through the film to be included an interlayer between the light incident side and the photovoltaic cells of a photovoltaic module. Part of the incoming visible light does not pass through but provides the decorative effect. Thereby a PV module is provided which not only allows the production of energy but also serves a decorative purpose.

Accordingly, the invention further relates to a photovoltaic module comprising a decorative film according to any of the claims 1-6, wherein the decorative film (4) is an interlayer between a front pane (5) and a layer comprising photovoltaic cells (8).

The photovoltaic module (PV module) is typically used as solar panel, and is in particular advantageous as a Building-Integrated Photovoltaic (BIPV) module. It combines the possibility of contributing to energy use reduction of the building towards more sustainability (nZEB or ZEB) and adding to the buildings' aesthetic value.

The invention further relates to a method for producing a photovoltaic module wherein adjacent to the graphics coating (1) side of the decorative film (4) (the light incident side) a bonding layer (6) is provided, which bonding layer is present between the graphics coating (1) side and the front pane (5), and wherein adjacent to the interference layer (3) side of the decorative film structure (4) (the side opposite of the light incident side) the photovoltaic cells (8) are provided, which are encapsulated in an encapsulant (7a, 7b). Examples of adhesives for bonding and encapsulant materials include EVA (ethylene vinyl acetate), POE (polyolefin elastomer), TPO (thermoplastic polyolefin), TPU (thermoplastic polyurethane) and PVB (polyvinyl butyral).

The invention further relates to infrastructure, in particular a building, comprising a PV module according to the invention.

The invention further relates to the use of a photovoltaic module according to the invention as a solar panel to produce electricity, and in particular further to change a visual appearance of an infrastructure.

The inventor in particular found that it is possible to provide a photo-voltaic module suitable to impart a different visual appearance compared to regular solar panels (with a uniform bluish or blackish surface) to, by providing both an interference coating and a graphics layer (comprising one or more colouring agents) on a single substrate and that can be treated as a single interlayer in the manufacturing process of the (BI)PV module. This enables the application of graphics, colours, and patterns into a PV module resulting in the possibility to add vibrant images and colours against minimal electrical losses. The invention also allows the provision of complex images, patterns or other graphic elements with a high resolution; the images may e.g. be photographic. The invention also allows for integration in various PV module shapes and dimensions. The PV module's decorative film structure (4) is also compatible with conventional PV glass, structured/ornamental glass, as well as plastic PV modules that may or may not maintain a degree of bendability.

It is in particular an advantage of a PV module according to the present invention that it addresses two critical barriers to broader BIPV adoption: aesthetics and performance. By enabling high customisability, the invention not only allows BIPV to visually mimic traditional architectural glass but also supports new, unique visual effects. It achieves these enhancements with relatively low loss in PV efficiency, ensuring both functional and visual integration in sustainable building designs. This is illustrated in the Example. It is further an advantage of the present invention that a decorative film is provided showing little or essentially none undesired diffusing light effects; such diffusing light is not available for electricity production, nor generally the intended decorative function. Such advantage is amongst others particularly strong in a decorative film with a graphics coating made with digital inkjet printing, such as dye sublimation or latex printing (with dots) and with an interference layer based on a cholesteric liquid crystal layer.

### BRIEF DESCRIPTION OF THE FIGURES

Figure 1 shows schematically the design of a typical decorative film (4) in accordance with the present invention, comprising the substrate film interlayer (2), the graphics coating (1) and the interference coating (3). The arrow shows the light incident side.
Figure 2 shows schematically a design of a preferred PV module according to the invention. The arrow shows the light incident side.
Figure 3 shows transmission graphs for four wavelengths (applied with 50 % ink density) of an exemplary PV module according to the invention (graphics coating made with dye sublimation; PET substrate film, cholesteric interference layer)
Figure 4 shows the current production of the exemplary PV module according to the invention, compared with a comparable black PV module.

The decorative film (4) typically essentially consists of the substrate film (inter)layer (2), the graphics coating (1) and the interference coating (3). The decorative film optionally comprises a UV blocker, which can be part of the substrate film layer, the graphics coating or the interference coating, e.g. a sublayer thereof. In a specific embodiment, such UV blocker is a separate layer of the decorative film The graphics coating and the interference coating are typically applied directly to the substrate film interlayer, although in a specific embodiment the graphics coating can be applied to the interference layer, whereby the interference layer is in between the substrate film and graphics coating. There is no need for encapsulant layers or other bonding layers between the substrate film interlayer and said coatings. Thus, the decorative film structure (4) is typically free of a separate diffuser layer. Preferably, the PV module is free of a separate diffuser layer, for a desirably thin PV module; further this simplifies production of the PV module. If desired, a diffuser function may be integrated in the substrate film (inter)layer, e.g. by roughening a surface of the substrate film (inter)layer, preferably the surface facing the interference layer. It is also possible to provide a substrate film (inter)layer made of a blend of transparent plastic and a diffuser material.

There is no need for encapsulant layers or other bonding layers between the substrate film (inter)layer (2) and the graphics coating (1) nor between the substrate film (inter)layer (2) and the interference layer. Thus, the decorative film (4) is typically free of encapsulant/bonding layers between any of the substrate film layer, the graphics coating and the interference layer. Thereby, the present invention offers the possibility to provide a decorative structure suitable for imparting a PV module with graphics, having a relatively low thickness. The decorative film (4) according to the invention respectively the decorative film (inter)layer (2) in the PV module of the invention, typically has a thickness of less than 500 micrometer. It typically has a thickness of more than 15 micrometer. Usually, the decorative film (interlayer) has a thickness in the range of about 30-to about 250 micrometer, preferably of about 30 to about 200 micrometer, in particular of 50-180 micrometer. Besides the flexible nature of the substrate film interlayer, the relatively low required thickness of the decorative structure also contributes to a high versatility in choice of the shape and size of PV modules. Further, a low thickness of the decorative structure is advantageous because it contributes to a low total thickness (and weight) of the PV module. Moreover, the relatively low thickness in combination with the low number of layers (by omitting layers between coatings and substrate, such as adhesive layers, diffuser layers), the production method is simplified and the production capacity (number of modules that can be produced per hour) can be increased.

The substrate film ((inter)layer) (2) generally forms a majority of the thickness of the decorative film (4); generally more than 50 %, preferably at least about 70 %, in particular at least 80 %, more in particular at least 85 %, at least 90 % or at least 95 % of the decorative film (4) thickness is the thickness of the substrate film (interlayer). The thickness of the substrate film interlayer (2) is less than 100 % of the total thickness of the decorative film (4), typically 99.9 % or less, preferably 99.5 % or less, in particular 99.0 % or less. In terms of layer thickness, the substrate film interlayer usually has a thickness of more than 10 micrometer, in particular or at least about 20 micrometer, more in particular at least about 30 micrometer. It's thickness is usually less than 250 micrometer, in particular about 200 micrometer or less, more in particular about 180 micrometer or less. The skilled person will be able to determine a suitable minimal thickness for the graphics coating and for the interference layer, based on the present disclosure and common general knowledge. As the skilled person understand the minimal thickness is a monolayer, determined by the nature of the dye respectively the interference material. The graphics coating (1), in particular when dye sublimation or the like has been used to apply it, usually has a thickness of 1 micrometer or less, in particular of 500 nm or less, e.g. 100 nm or less or 50 nm or less. E.g. a thickness of 1 nm or more, 5 nm or more, 20 nm or more, or 50 nm or more is feasible, e.g with dye sublimation. In principle it is also possible to provide a thicker graphic layer, such as of up 10 about 30 micrometer, with conventional printing techniques. The interference layer usually has a thickness in the range of about 3-10 micrometer. In a specific embodiment, the thickness is less than 3 micrometer, in particular about 40 nm or more.

The substrate film interlayer is generally a plastic layer. Advantageously the substrate film interlayer is a flexible polymeric material. The substrate film (inter)layer (2) is consider flexible in particular if it can be bend around a cylinder with a diameter of 25 mm. With respect to optical properties, the substrate film (inter)layer (2) preferably has a Gardner haze, as determinably by ASTM D1003 as applicable 1 November 2024 of between 0 and 10 %, preferably of about 5 % or less. In practice, there is usually some haze measurable , such as a Gardner haze of about 1 % or more, in particular about 2 % or more. Particularly good results have been achieved with a polyethylene terephthalate (PET) as a substrate film. PET offers a high transparency, good bendability and has been found to be well-printable with a graphics coating, also when using dye sublimation, and it has been found to be a good substrate for adherence of an interference layer, also when a cholesteric liquid crystal coating is used. Alternatively another material may be used for the substrate film interlayer, e.g. a polycarbonate film.

Good results having in particular be achieved with a cholesteric interference layer, also without a separate diffuser layer. The use of a cholesteric interference layer has in particularly found advantageous in that the light wavelengths (bandwidth) of which reflection is needed (to obtain an intended decorative effect) is well-controllable. Further, the inventor found that a cholesteric interference layer offers a benefit in electricity producing performance of the PV module. The inventor concluded that this is due to the fact that the interference effect needed for the intended decorative effect is satisfactorily achieved without needing to reflect all the light having a wavelength in the bandwidth(s) that is to be used for the decorative effect. With the cholesteric interference layer a substantial part of that light can pass through the coating, thereby becoming available for electricity production. Transmission through the interference layer of the amount of light of the bandwidth(s) used for decorative purposes can be in the range of 30-70%, in particular 40-60 %, more in particular about 50 %.. A cholesteric coating material is typically selected from cholesteric liquid crystals. The cholesteric interference layer (3) can in be based on the disclosure of EP3 995 884 A1, the contents of which are incorporated herein by reference, with the proviso that the ultraviolet blocking material as a (sub) layer of the interference layer is optional. A decorative film (4) or PV module according to the invention can be without a UV blocking material or a UV blocking material, if desired, can be provided in another layer, such as in the substrate film (2), the graphics coating, or more towards the light incident side, such as in the front pane or between the front pane and the graphics coating (1).

The cholesteric liquid crystal layer can prepared from a liquid crystal mixture comprising a polymerizable liquid crystal monomer, a polymerizable chiral dopant and a photo-initiator. Advantageously, the polymerizable chiral dopant is a levorotatory chiral dopant, and the liquid crystal mixture comprises the polymerizable liquid crystal monomer, 1.2-6.5 wt% of the levorotatory chiral dopant and 0.5-5 wt% of the photo-initiator; or the polymerizable chiral dopant is a dextrorotatory chiral dopant, and the liquid crystal mixture comprises the polymerizable liquid crystal monomer, 2.6-18.8 wt% of the dextrorotatory chiral dopant and 0.5-5 wt% of the photo-initiator.

Various suitable chiral dopants, photo-initiators and liquid crystal monomers are well known in the art. The skilled person will be able to select others based on the present disclosure, the prior art cited herein and common general knowledge.

The levorotatory polymerizable chiral dopant can be used to modulate the cholesteric liquid crystal into the dextrorotatory cholesteric liquid crystal. En example of a levorotatory polymerizable chiral dopant is (3R, 3aR, 6S, 6aR)-hexahydro furan [3,2-b] furan-3,6-diyl bis(4-((4-((((4-(acryloyloxy)butoxy)carbonyl)oxy)benzoyl)oxy)benzoate).

The dextrorotatory polymerizable chiral dopant can be used to modulate the cholesteric liquid crystal into the levorotatory cholesteric liquid crystal.

In an embodiment, the polymerizable liquid crystal monomer material includes 2-(methoxycarbonyl)-1,4-phenylene-bis(6-((((4-(acryloyloxyoxy)ethoxy)carbonyl)oxy)-2-naphthoic acid).

The cholesteric liquid crystal layer can be formed of a single cholesteric liquid crystal layer of be formed of two or more cholesteric liquid crystal sub-layers (and optionally one or more UV blocking material sub-layers. In embodiment, a first cholesteric liquid crystal sublayer and a second cholesteric liquid crystal sublayer have different chirality.

In an embodiment, at least one of the cholesteric liquid crystal layers further comprises an organic solvent in which a surfactant is dissolved in. Particularly suitable surfactants include polyacrylate-based surfactant, e.g. e selected from the group consisting of Byk-361N, Byk-378, Byk-UV 3510 and Byk-Dynwet 800N. The surfactant can improve wettability of the cholesteric liquid crystal solution.

A single cholesteric layer has been found a surprisingly effective interference coating. There is no need to provide a plurality of sub-layers with sequentially higher and lower refractive indices to create an effective interference layer. Thus, the cholesteric layer can have an essentially uniform refractive index. Further in combination with the flexible substrate interlayer, in particular a PET substrate interlayer, it has been found that a cholesteric coating shows maintains good adherence to the substrate film interlayer also when the decorative film structure or even the PV module as a whole is bent. This is interesting in case the other layers of the PV module are also bendable, because it can facilitate installation, adds to architectural design options or make the PV module more robust during transportation, handling or after installation.

The graphics coating advantageously comprises one or more organic dyes, preferably one or more organic dyes printed by dye sublimation. Suitable organic dyes are generally known in the art. In an advantageous embodiment, the graphics coating at least substantially consists of one or more organic dyes. In combination with the flexible substrate interlayer, in particular a PET substrate interlayer, it has been found that an organic dye coating, in particular a dye-sublimated coating, maintains good adherence to the substrate film interlayer also when the decorative film structure or even the PV module as a whole is bent (in case the other layers are also bendable). An important advantage of dye-sublimated coating has been found the high transmissivity of light and the durability of the coating.

In addition or alternatively the graphic coating may comprise one or more pigments. In particular, a latex printed pigment coating is a preferred pigment based coating as an alternative to organic dye, albeit typically with a somewhat lower transmittivity of the decorative film and somewhat lower current output of the PV module than feasible with organic dyes, in particular compared to dye-sublimated graphic coatings.

Generally, the PV module according to the invention comprises a front pane, which is positioned at the light-incident side, when the PV-module properly installed for generating electricity. The front pane can be of any front pane suitable for use as a PV module front pane. The material can be glass or plastic, the front pane can have any size or shape. The front pane can be made of a flat PV glass or plastic, such as a conventional PV glass. The present invention in particular offers an advantageous PV module, wherein the front pane has a curved surface, due to the advantageous use in particular of the graphics film structure's bendability. The present invention in particular offers an advantageous PV module, wherein the front pane is made of a structured, texturised, or ornamental glass or plastic or of a frosted glass or plastic. Such front pane has been found to contribute to a particular visual effect, whilst providing a satisfactory electricity production, in particular in combination with the interference coating, such as a cholesteric liquid crystal coating. Both such interference coating and the light incident surface of the structurised/texturised/ornamental/frosted front pane may contribute to a specific visual effect, namely a view angle dependent visual appearance (an iridescent effect). The visual appearance may change dependent in the view angle in terms of colour, in terms of visual image or both.

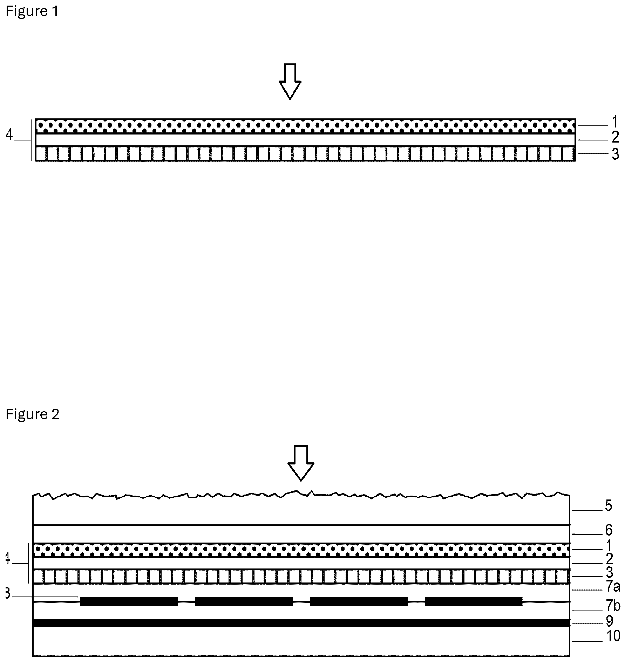

Figure 2 schematically shows a preferred PV module according to the invention. Photovoltaic module according to any of the claims 1-10, wherein adjacent to the graphics coating (1) side of the decorative film structure (4) (the light incident side) a bonding layer (6) is provided, which bonding layer is present between the graphics coating (1) side and a front pane (5), and wherein adjacent to the interference layer (3) side of the decorative film structure (4) (the side opposite of the light incident side) photovoltaic cells (8) are provided, which are typically encapsulated in an encapsulant (7a, 7b). The PV module further generally comprises a support (10), such as a glass, composite, metal (such as aluminium) or plastic back sheet. The photovoltaic cells (8) are then positioned between the support (10) and the decorative film structure (4). The support is usually provided with a dark-coloured layer (9), such as a black pigment or black dye. The presence of the dark-coloured layer is advantageous for a desirable visual appearance at the light incident side. In the absence of such a layer, undesired visual inhomogeneity or distortions may appear. Suitable photovoltaic cells, supports, encapsulants, adhesives and dark-coloured layers are generally known in the art.

The invention further relates to a method for producing a photovoltaic module. Usually the substrate film interlayer (2) is provided with the interference coating (3) and thereafter the graphics coating is applied.

The interference coating can be applied by any suitable technique, e.g. spin coating, slot-die coating, blade coating, dip coating, bar coating, spray coating, vapour deposition, roll coating, shear alignment coating, electrohydrodynamic coating, langmuir-blodgett technique, thermal evaporation coating, screen printing, inkjet printing. In particular the cholesteric coating can be applied by a method based on EP 3 995 884A1 E.g. the method can comprise coating the liquid crystal mixture on the first ultraviolet blocking material; and conducting a heating and ultraviolet radiation treatment to enable the liquid crystal mixture to form a cholesteric liquid crystal (sub)layer. The cholesteric liquid crystal can be dissolved in an organic solvent comprising at least one of the following materials: cyclopentanone, methyl ethyl ketone, cyclohexanone and toluene. In an embodiment, the heating and ultraviolet radiation treatment comprises: heating the cholesteric liquid crystal at 100°C to 120°C for at least 30 seconds. In an embodiment the heating and ultraviolet radiation treatment further comprises: irradiating the cholesteric liquid crystal by using long-wave ultraviolet rays at a light intensity of at least 50mJ/cm² .

The graphics coating (2) can in principle be applied by any suitable printing technique for the used colouring agent(s), including dye sublimated dyes, latex printed colouring agents and UV colouring agents . Particularly good results have been achieved by dye sublimation, for which typically one or more organic dyes are used. Other suitable techniques include UV print, latex print, thermal transfer print and other digital printing techniques. In a specific embodiment, the interference layer (3) is applied to the substrate film (4), such as a PET film, and the graphics coating (1) is applied to the interference layer (3). The application of the graphics coating can advantageously be applied with UV ink, latex ink or another ink adhering to the interference layer.

The PV module according to the invention can in principle be installed on any structure suitable for supporting PV modules. The PV modules of the invention are particularly advantageous, when installed to an outdoor surface of a building or other infrastructure, such as an infrastructure selected from dams, dykes, sound barrier walls and embankments. In a highly preferred embodiment, the infrastructure is a building, of which an outdoor wall or rooftop is provided with a plurality of PV modules according to the invention.

Terminology used for describing particular embodiments is not intended to be limiting of the invention. Generally terms as used herein are as generally used in the art. As used herein, the singular forms "a", "an" and "the" are intended to include the plural forms as well, unless the context clearly indicates otherwise. The term "and/or" includes any and all combinations of one or more of the associated listed items. It will be understood that the terms "comprises" and/or "comprising" specify the presence of stated features but do not preclude the presence or addition of one or more other features. It will be further understood that when a particular step of a method is referred to as subsequent to another step, it can directly follow said other step or one or more intermediate steps may be carried out before carrying out the particular step, unless specified otherwise. Likewise it will be understood that when a connection between structures or components is described, this connection may be established directly or through intermediate structures or components unless specified otherwise. In the drawings (figures), the absolute and relative sizes of systems, components, layers, and regions may be exaggerated for clarity. Embodiments may be described with reference to schematic and/or cross-section illustrations of possibly idealised embodiments and intermediate structures of the invention. In the description and drawings, like numbers refer to like elements throughout. Relative terms as well as derivatives thereof should be construed to refer to the orientation as then described or as shown in the drawing under discussion. These relative terms are for convenience of description and do not require that the system be constructed or operated in a particular orientation unless stated otherwise.

The term "(at least) substantially)" or "essentially" is generally used herein to indicate that it has the general character or function of that which is specified. When referring to a quantifiable feature, this term is in particular used to indicate that it is at least 50 %, more in particular more than 75 %, even more in particular more than 90 %, even more in particular at least 95 % of the maximum of that feature. The term 'essentially free' is generally used herein to indicate that a substance, material, layer or other entity is not present (below the detection limit achievable with analytical technology as available on the effective filing date) or present in such a low amount that it does not significantly affect the property of the product that is essentially free of said substance. In practice, in quantitative terms, a product is usually considered essentially free of a substance, if the content of the substance is 0 - 1 wt.%, in particular 0 - 0.5 wt.%, more in particular 0 - 0.1 wt.%.

In the context of this application, the term "about" means generally a deviation of 10 % or less from the given value, in particular a deviation of 5% or less, more in particular a deviation of 2% or less.

For the purpose of clarity and a concise description, features are described herein as part of the same or separate embodiments, however, it will be appreciated that the scope of the invention may include embodiments having combinations of all or some of the features described.

Next the method of the present disclosure will be illustrated by the following example.

### EXAMPLE

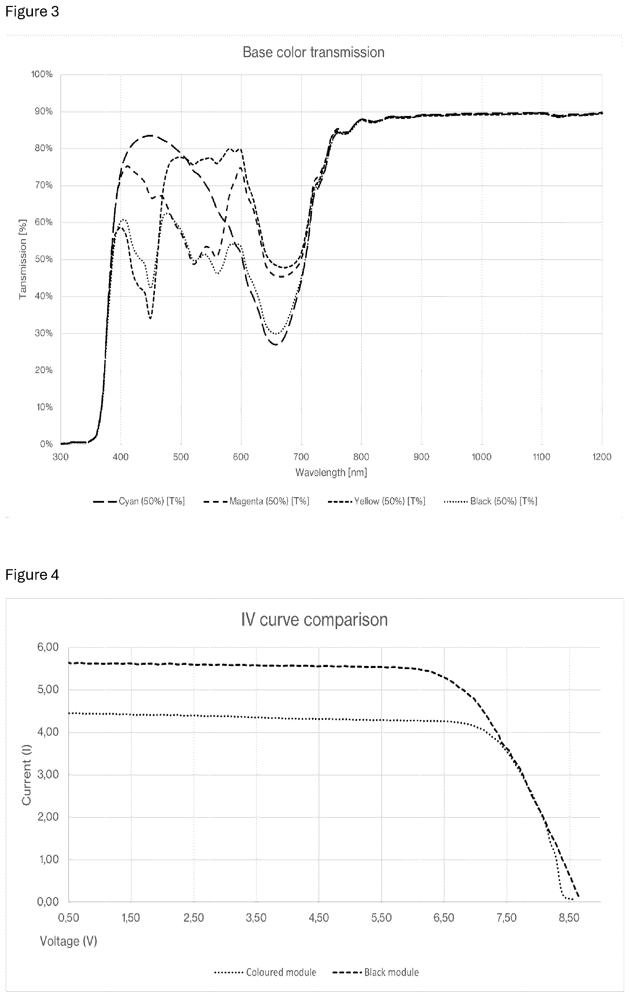

A flexible PET film (thickness 30-180 micrometer, Gardner haze of 2-5 % was provided with interference coating on one side in accordance with EP3 995 884 A1. On the opposite side of the PET film a graphics layer was provided by dye sublimation with ink densities varying from 0-80% for individual CMYK channels. The resultant decorative film was used for the production of a PV module, as schematically shown in Figure 2. Figures 3 and 4 show the test results.

The transmission graph of Figure 3 shows the percentage of light that passes through the decorative film for different wavelengths of light. The different lines show the transmissive properties of different base colours (CMYK) in the graphics coating (1). In the example a red reflecting interference coating (3) was used, hence the dip in the curves around 670 nm.

Figure 4 shows that the provision of the graphics coating (in this case with an ink density of 50%) results in only a relatively small loss of produced current, despite the presence of the colour.

## Claims

1. A decorative film (4) for a photovoltaic module, comprising a graphics coating (1), a substrate film layer (2) and an interference layer (3).

2. A decorative film (4) according to claim 1, wherein the substrate film layer is a substrate film interlayer (2), wherein the graphics coating (1) is present at a first side of the substrate interlayer (2), and the interference layer (3) is present at a second, opposing side of the substrate film interlayer.

3. Decorative film according to claim 1 or 2, wherein the interference layer (3) is a cholesteric liquid crystal layer.

4. Decorative film according to any of the claims 1-3, wherein the substrate film interlayer is a polyethylene terephthalate (PET) layer.

5. Decorative film according to any of the claims 1-4, wherein the graphics coating comprises one or more organic dyes, preferably one or more organic dyes printed by dye sublimation.

6. Decorative film according to any of the claims 1-5, wherein the decorative film structure has a thickness of about 30 to about 200 micrometer, of which preferably at least 70 % is the thickness of the substrate film layer (2), more preferably 85-99.9 %.

7. Photovoltaic module, comprising a decorative film according to any of the claims 1-6, wherein the decorative film (4) is an interlayer between a front pane (5) and a layer comprising photovoltaic cells (8).

8. Photovoltaic module according to claim 7, wherein the front pane (5) is a curved glass or curved plastic front pane.

9. Photovoltaic module according to claim 7 or 8, wherein the front pane (5) is a structured, texturised or ornamental glass or structured, texturised or ornamental plastic front pane.

10. Photovoltaic module according to any of the claims 7-9, wherein the front pane (5), is a frosted glass or frosted plastic front pane.

11. Photovoltaic module according to claim 7 or 8, wherein the front pane is a clear glass or clear plastic front pane.

12. Photovoltaic module according to any of the claims 7-11, wherein a visual appearance on a light incident surface side of the photovoltaic module is dependent on a view angle.

13. Photovoltaic module according to any of the claims 7-12, wherein adjacent to the graphics coating (1) side of the decorative film (4) (the light incident side) a bonding layer (6) is provided, which bonding layer is present between the graphics coating (1) side and the front pane (5), and wherein adjacent to the interference layer (3) side of the decorative film structure (4) (the side opposite of the light incident side) the photovoltaic cells (8) are provided, which are encapsulated in an encapsulant (7a, 7b).

14. Method for producing a photovoltaic module according to any of the claims 7-13, comprising
providing the substrate film interlayer (2) comprising the interference layer (3) and applying the graphics coating by dye sublimation.

15. Infrastructure, comprising an outside surface comprising a plurality of photovoltaic modules according to any of the claims 7-13, preferably an infrastructure selected from dams, dykes, sound barrier walls, embankments and buildings, more preferably a building, in particular a building of which one or more outdoor walls or one or more rooftops are provided with the photovoltaic module.
